(19) **Europäisches Patentamt**
**European Patent Office**
**Office européen des brevets**

(11) **EP 2 056 361 A1**

(12) **EUROPEAN PATENT APPLICATION**

(43) Date of publication:
**06.05.2009 Bulletin 2009/19**

(51) Int Cl.:
*H01L 31/055* (2006.01)  *F21V 8/00* (2006.01)
*F24J 2/06* (2006.01)

(21) Application number: **08103860.6**

(22) Date of filing: **07.05.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **01.11.2007  AU 2007231811**

(71) Applicant: **Tropiglas Technologies Ltd**
**Yokine WA 6060 (AU)**

(72) Inventor: **Baranov, Vladimir Kuzmich**
**Yokine WA 6060 (AU)**

(74) Representative: **Hellmich, Wolfgang**
**European Patent and Trademark Attorney**
**Ernsbergerstrasse 14**
**81241 München (DE)**

(54) **Selective radiation-inhibiting optical element**

(57)    The present invention provides an optical element comprising one or more layers for inhibiting a selected wavelength portion of incident radiation while allowing the remaining portion to pass through the optical element. The layers comprise luminescent materials, which inhibit the selected wavelength portion by absorption and emission of the selected wavelength range as luminescent radiation. A substantial portion of the luminescent radiation is directed towards the edges of the optical element.

FIG 2

EP 2 056 361 A1

**Description**

The present invention relates to an optical element. More specifically, the present invention relates to an optical element, selectively inhibiting a portion of the electromagnetic radiation incident on the optical element, while allowing the remaining portion of electromagnetic radiation to pass through the optical element.

The term "optical element", as used herein, is not limited to use with visible radiation but is applicable to all forms of electromagnetic radiation, including but not limited to microwave, infrared, visible, ultraviolet, X-ray and gamma radiation.

Nowadays, glass is increasingly being used in diverse fields such as the automotive industry, the construction industry, and so forth. When glass is used in the automotive and construction industries, it is desirable to filter out certain components of solar radiation. For example, in tropical countries, it is preferable to filter out the infrared component of solar radiation to improve thermal comfort and reduce the cost of air-conditioning. Similarly, in regions with colder climates, it is desirable to reduce heat loss from the interiors of buildings to the outside.

There exist some methods in the prior art for reducing infrared and ultraviolet components of electromagnetic radiation, for example, metallised surface glass, tinted glass and electro-chromic glass. In addition, several glazing materials are available to impart the desired qualities to glass.

Although metallised surface glass and tinted glass are frequently used, they also inhibit visible radiation along with infrared radiation. Moreover, tinted glass gets heated by absorbing infrared radiation, and, in turn, becomes a source of infrared radiation.

Electro-chromic glass includes multiple layers of film (around four or five films), of which the outer film and the film next to the transparent layer are transparent electrodes. A voltage applied across the transparent electrodes controls the transparency of the intermediate films. However, this method is expensive and therefore cannot be widely used in office and industrial buildings.

The most widespread method of radiation control uses glazing material in conjunction with normal glass. The composition of the glazing material is such that the absorption coefficient for infrared radiation is significantly higher than the absorption coefficient for visible radiation. However, such glazing absorbs infrared radiation, thereby heating the glass plate, resulting in the glass plate becoming a source of infrared radiation. Moreover, the transmission coefficient of the resulting glass plate, for visible radiation, is lower than that of an ordinary glass plate.

Another kind of optical element uses luminescent materials to inhibit the undesirable components of solar radiation. However, the luminescent materials tend to impart a certain colour to the glass. For example, certain optical elements use dyes, since infrared-inhibiting materials impart a certain characteristic colour to the glass, and therefore, result in significant degradation of natural lighting in the interiors.

Thus, existing methods use either reflection or absorption as the primary method for inhibiting the undesirable portion of the solar radiation. In certain jurisdictions, the use of radiation control employing reflection is prohibited by law. Moreover, these existing methods do not inhibit infrared radiation and transmit visible radiation through the optical element to a satisfactory extent.

In the light of the foregoing discussion, there is a need for a system and method for improving efficiency in the selective inhibition of a selected portion of electromagnetic radiation and substantially transmit the visible light at the same time. Therefore, the optical element should not only inhibit a selected part of electromagnetic radiation, for example, infrared radiation or ultraviolet radiation, but also transmit visible radiation with improved efficiency. Moreover, it is desirable to avoid additional layers to impart the desired properties of the optical element.

An object of the present invention is to provide an optical element to inhibit the first wavelength range of electromagnetic radiation, while permitting substantial transmission of a second wavelength range of electromagnetic radiation.

Accordingly, the present invention provides an optical element comprising one or more layers. The one or more layers are optically coupled in a face-to-face relationship with each other. At least one of the one or more layers of glass comprises one or more luminescent materials that inhibit the first wavelength range of electromagnetic radiation, while the second wavelength range of electromagnetic radiation is permitted to pass through.

In accordance with various embodiments of the present invention, the first wavelength range corresponds to either infrared radiation or ultraviolet radiation. The luminescent materials spectrally transform at least one of infrared radiation or ultraviolet radiation into luminescent radiation. The luminescent radiation is reflected internally from the one or more layers of the optical element and is directed to the edge of the optical element.

In accordance with an embodiment of the present invention, at least one of the one or more layers comprises at least one reflecting or tinting material. Further, in accordance with another embodiment, the optical element comprises a polymeric layer, the polymeric layer comprising one or more luminescent materials.

In accordance with another embodiment of the present invention, the optical element comprises a plurality of layers, the plurality of layers being arranged in such a way that the luminescent radiation from a first layer of the plurality of layers is inhibited by a second layer of the plurality of layers.

The present invention improves the efficiency of the inhibition of a selected portion of the incident radiation to about 80 percent. Further, the present invention permits substantial transmission of the remaining portion of the incident radiation. Therefore, the present invention enables a substantially transparent optical element with effective infrared radiation-inhibiting properties.

Various embodiments of the present invention will hereinafter be described in conjunction with the appended drawings, provided to illustrate and not to limit the present invention, wherein like designations denote like elements, and in which:

FIG. 1 illustrates a schematic representation of an optical element, in accordance with an embodiment of the present invention.

FIG. 2 illustrates the path of luminescent radiation in the optical element, in accordance with an embodiment of the present invention.

FIG. 3 illustrates a schematic representation of a cascading arrangement in the optical element, in accordance with an embodiment of the present invention.

FIG. 4 illustrates a schematic representation of an optical element comprising a single glass layer, in accordance with an embodiment of the present invention.

FIG. 5 illustrates a schematic representation of an optical element with surface deformities, in accordance with an embodiment of the present invention.

FIGS. 6A through 6E illustrate various methods for controlling luminescent radiation emitting from the optical element, in accordance with various embodiments of the present invention.

The present invention provides an optical element including one or more layers, to inhibit a first wavelength range of the incident radiation while allowing a second wavelength range to pass through the optical element. Specifically, the optical element includes one or more luminescent materials dispersed in at least one of the one or more layers, to inhibit the first wavelength range. The one or more luminescent materials absorb a selected portion of the incident radiation corresponding to the first wavelength range and spectrally transform the first wavelength range into a luminescent radiation. Subsequently, a substantial portion of the luminescent radiation is directed towards the edges of the one or more layers.

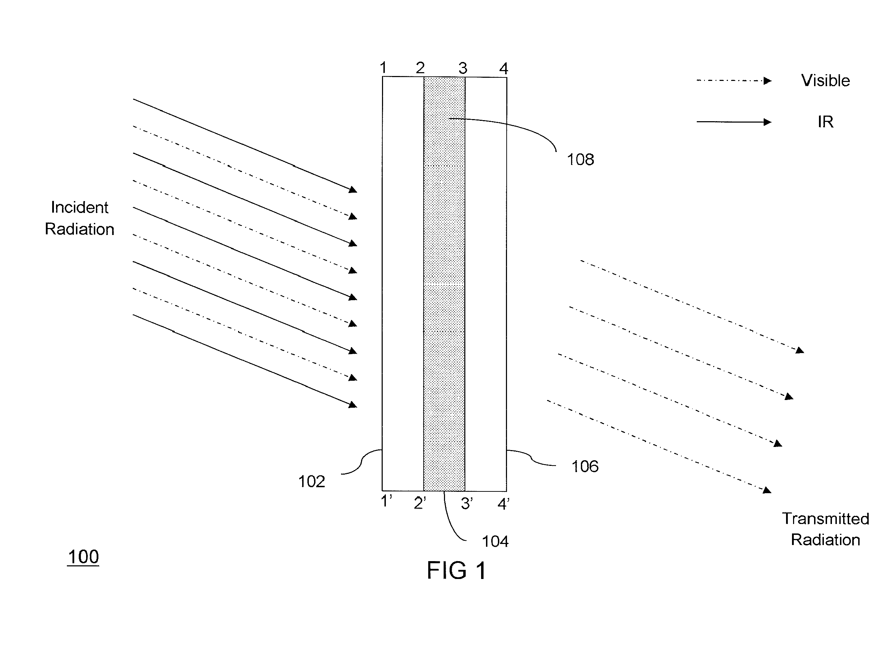

FIG. 1 illustrates a schematic representation of an optical element 100, in accordance with an embodiment of the present invention. Optical element 100 includes one or more layers, namely, a layer 102, a layer 104 and a layer 106, which are optically coupled with each other in a face-to-face relationship. Layer 104 includes one or more luminescent materials 108. Fig. 1 also illustrates incident and transmitted radiation, optical interface 1-1', optical interface 2-2', optical interface 3-3' and optical interface 4-4'.

The incident radiation including a first wavelength range and a second wavelength range is incident on optical element 100, with the incident radiation passing through layer 102, layer 104 and layer 106. One or more luminescent materials 108 absorb and transform the first wavelength range into luminescent radiation. The luminescent radiation is directed towards an edge of optical element 100. The second wavelength passes through optical element 100 to emerge as the transmitted radiation.

In accordance with an embodiment of the present invention, the incident radiation incident on optical element 100 includes ultraviolet radiation, visible radiation and infrared radiation. One or more luminescent materials 108 absorb the infrared and ultraviolet radiation and permit the visible radiation to pass through optical element 100.

In accordance with another embodiment of the present invention, the incident radiation is the solar radiation that includes infrared radiation, ultraviolet radiation and visible radiation. Ultraviolet radiation includes UV-A, UV-B and UV-C components, which are categorised on the basis of their wavelength range. UV-A has a wavelength range varying from about 315 nm to about 400 nm, UV-B a wavelength range varying from about 280 nm to about 315 nm, and UV-C a wavelength range varying from about 100 nm to about 280 nm.

In accordance with an embodiment of the present invention, the first wavelength range varies from about 600 nm to about 2500 nm, while the second wavelength range varies from about 400 nm to about 600 nm.

In accordance with another embodiment of the present invention, the first wavelength range varies from about 100 nm to about 400 nm and the second wavelength range varies from about 400 nm to about 600 nm.

In accordance with yet another embodiment of the present invention, the first wavelength range includes wavelength ranges varying from about 100 nm to about 400 nm and from about 600 nm to about 2500 nm, while the second wavelength range varies from about 400 to about 600 nm.

Layers 102, 104 and 106 are optically coupled in a face-to-face relationship with each other. Optical interface 2-2' is the interface between the layers 102 and 104. Similarly, optical interface 3-3' is the interface between the layers 104 and 106. Optical interface 1-1' and optical interface 4-4' are the interfaces between the surroundings and the layers 102 and 106, respectively. The one or more layers can be made of either organic or inorganic glass. Examples of the materials of the one or more layers include, but are not limited to, polymethylmethacrylate, quartz, and the like.

In accordance with an embodiment of the present invention, optical element 100 also includes a polymeric layer, which includes the one or more luminescent materials 108. The polymeric layer is applied to at least one of the surfaces of optical element 100. Examples of the materials used in the polymeric layer include, but are not limited to, Polyvinyl Butyral (PVB). In accordance with an embodiment of the invention, the polymeric layer is an adhesive film which can be applied to at least one of the surfaces of the optical element 100.

One or more luminescent materials 108 are evenly distributed in layer 104. Each luminescent material 108 is characterized by its absorption band. The absorption band refers to the wavelength range the luminescent material 108 can absorb and spectrally transform into luminescent radiation of a higher wavelength range. One or more luminescent materials 108 can be either organic or inorganic. Examples of organic luminescent material include, but are not limited to, organic dyes. Similarly, examples of inorganic luminescent materials include, but are not limited to, one or more rare-earth elements. The one or more rare-earth elements are selected from the group consisting of Cerium, Ytterbium, Samarium, Erbium and Terbium, and combinations thereof. In various embodiments of the present invention, the one or more rare-earth elements may be present in the form of pure elements, salts of rare-earth elements or compounds. The one or more layers incorporating one or more luminescent materials 108 may be referred to as optically active layers.

According to yet another embodiment, reflective or tinting materials may be used in addition to one or more luminescent materials 108. Examples of reflective materials include, but are not limited to, metal sulphides such as lead sulphide (PbS), copper sulphide (CuS), a combination of lead sulphide and copper sulphide (PbS-CuS), and the like.

Various applications of optical element 100 include, but are not limited to, window panes in buildings and window panes, window shields, sunroofs and sun visors in automobiles.

Various embodiments of the present invention will hereinafter be described in context of the first wavelength being infrared radiation, the second wavelength range being visible radiation, and the one or more luminescent materials 108 being the one or more rare-earth elements. It should be noted that various embodiments of the present invention are equally applicable to other variations of the first wavelength, the second wavelength and the luminescent materials, as discussed in conjunction with FIG. 1.

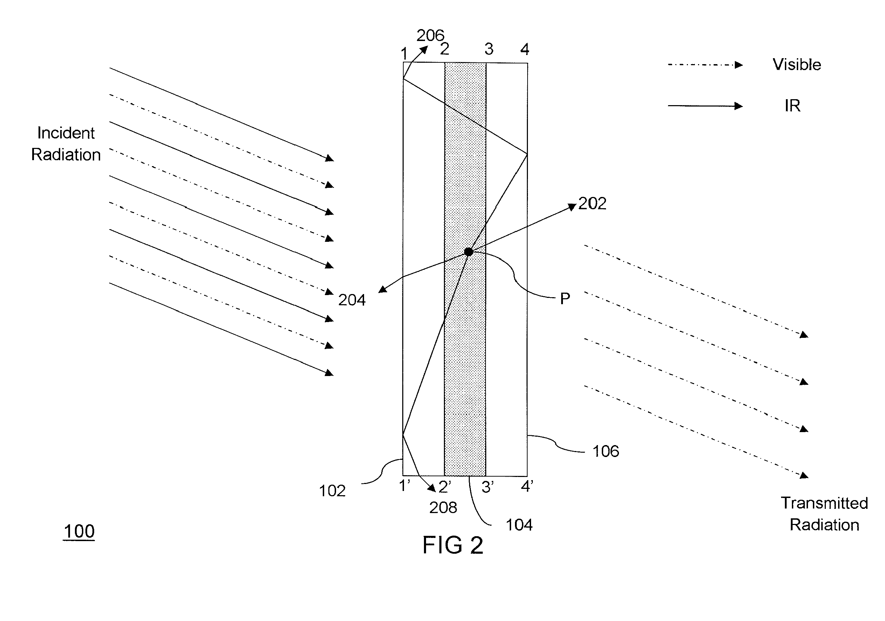

FIG. 2 illustrates a path of luminescent radiation in optical element 100, in accordance with an embodiment of the present invention. Layer 104 includes one or more rare-earth elements 108 dispersed in layer 104. Fig. 2 also shows a ray 202, a ray 204, a ray 206 and a ray 208 being emitted from the exemplary particle of one or more rare-earth elements 108, particle P. When the incident radiation that includes visible radiation and infrared radiation falls on optical element 100, layer 102 allows the incident radiation to pass through unaffected. When the incident radiation traverses through layer 104, each particle of one or more rare-earth elements 108 absorbs infrared radiation and subsequently emits luminescent radiation at longer wavelengths in all directions. A small portion of the luminescent radiation represented by ray 202 and ray 204 are emitted through the front and back surfaces of optical element 100, respectively. However, a large portion of the luminescent radiation represented by ray 206 and ray 208 is trapped inside optical element 100 due to the total internal reflection at optical interface 1-1' and 4-4' of optical element 100, and is directed towards the edges of optical element 100.

The quantity of the luminescent radiation 'trapped' inside optical element 100, due to total internal reflection, is a function of the relative refractive indices of the one or more layers. The relative refractive indices of the one or more layers are defined with respect to the surrounding medium. In an exemplary embodiment of the present invention, optical element 100 is surrounded by air. Therefore, the quantity of luminescent radiation trapped inside optical element 100 is defined by equation 1:

$$\sin n = 1/r \ldots\ldots 1$$

where 'r' is the relative refractive index of the one or more layers and 'n' is the angle of total internal reflection.

The fraction of total luminescent radiation emitted, trapped between the front and back surfaces of the optical element and directed towards the edges, is defined by equation 2:

$$N = \cos n \ldots\ldots\ldots 2$$

Therefore, 'N' may be expressed in terms of 'r', as defined by equation 3:

$$N = (1-r^{-2})^{1/2} \ldots\ldots 3$$

Glass materials used to make the one or more layers include ordinary silicate or organic glass with a refractive index that is close to 1.5. Substituting r =1.5 in equation 3 gives:

$$N = (1-1.5^{-2})^{1/2} = 75\% \text{ (approx)}$$

Thus, approximately 75 percent of the luminescent radiation is emitted through the edges of optical element 100. Further, assuming the optical interface 1-1' and the optical interface 4-4' of optical element 100 to be flat, the luminescent radiation through each interface is approximately 12.5 percent. Visible radiation passes through optical element 100 substantially.

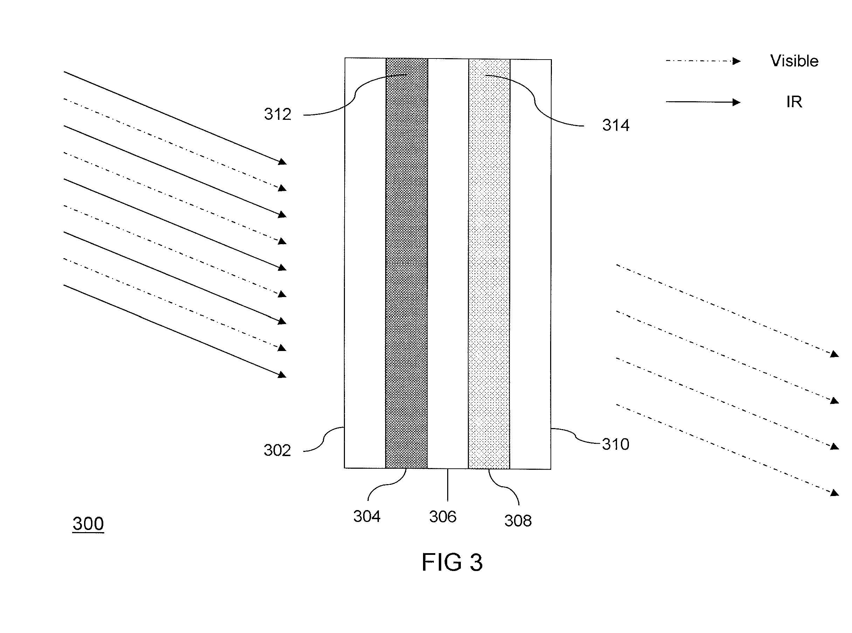

FIG. 3 illustrates a schematic representation of a cascading arrangement in an optical element 300, in accordance with an embodiment of the present invention. Optical element 300 includes a layer 302, a layer 304, a layer 306, a layer 308, and a layer 310. Layer 304 and layer 308 include a rare-earth element 312 and a rare-earth element 314, respectively. Layer 304 and layer 308 are also referred to as optically active layer 304 and optically active layer 308, respectively. Similarly, layer 302, layer 306 and layer 310 are referred to as optically inactive layer 302, optically inactive layer 306 and optically inactive layer 310, respectively. The incident radiation, including infrared radiation and visible radiation, is incident on optical element 300. When the infrared radiation traverses through layer 304, rare-earth element 312 absorbs a selected portion of the infrared wavelength range and emits spectrally transformed radiation as the luminescent radiation.

In accordance with an embodiment of the present invention, rare-earth element 312 and rare-earth element 314 are such that the absorption band of rare-earth element 314 coincides with the band of luminescent radiation of rare-earth element 312. Therefore, the luminescent radiation emitted by rare-earth element 312, while traversing through layer 306, is absorbed by rare-earth element 314. This arrangement of the one or more layers effectively inhibits infrared radiation.

Those skilled in the art will appreciate that the cascading effect, explained herein, may be extended to multiple layers that are arranged in various combinations of optically active and optically inactive layers.

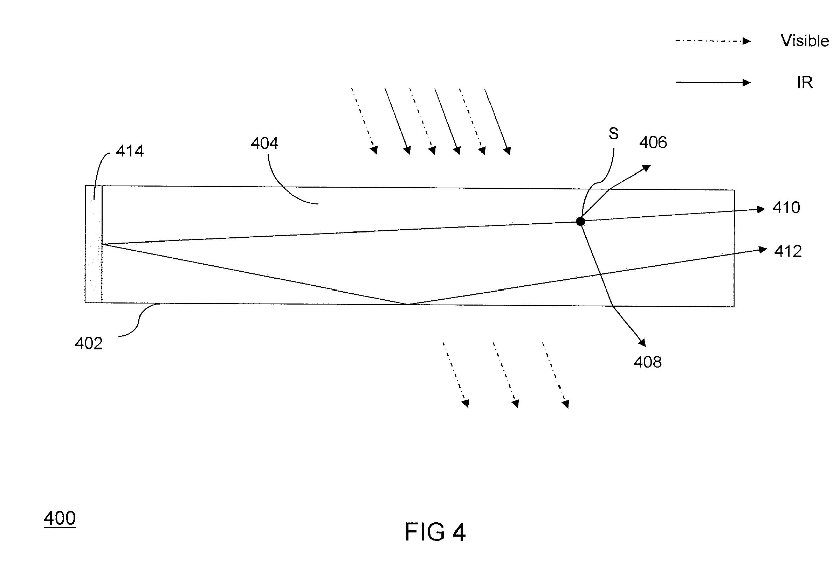

FIG. 4 illustrates a schematic representation of an optical element 400 comprising a single glass layer, in accordance with an embodiment of the present invention. Single glass layer 402 includes one or more rare-earth elements 404. Fig. 4 also shows a ray 406, a ray 408, a ray 410 and a ray 412 being emitted from an exemplary particle of one or more rare-earth elements 404, particle S. Optical element 400 also includes a mirror reflective layer 414 on its three edges. When the incident radiation, including infrared and visible radiation, traverses through single glass layer 402, one or more rare-earth elements 404 absorb infrared radiation and emit luminescent radiation. A portion of the luminescent radiation, such as ray 406 and ray 408, is emitted from the surface of optical element 400, while a substantial portion of the luminescent radiation, such as ray 410 and ray 412, is directed and emitted from the edges of single layer 402. If one or more edges of optical element 400 are coated with mirror reflective layer 414, as depicted in the figure, the luminescent radiation is emitted through the remaining edges, which is free of mirror reflective layer 414.

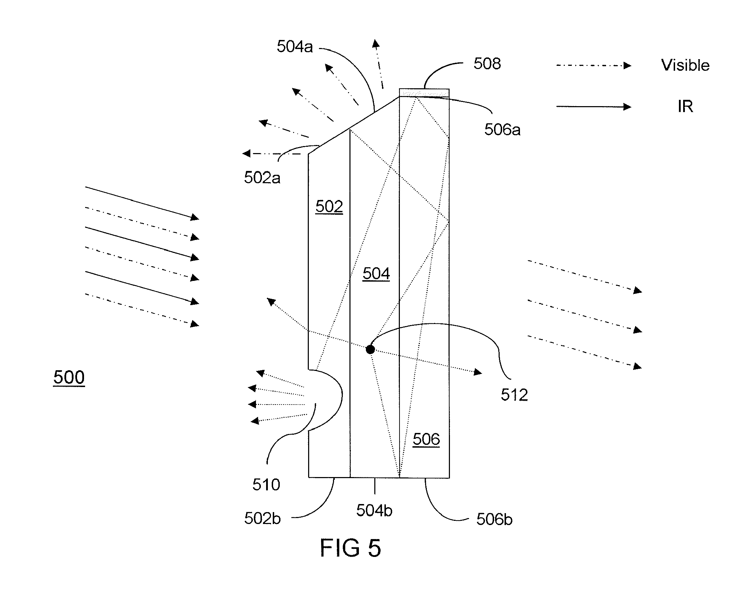

FIG. 5 illustrates a schematic representation of an optical element 500 comprising surface discontinuity, in accordance with an embodiment of the present invention. Optical element 500 includes a layer 502 with an edge 502a and an edge 502b, a layer 504 with an edge 504a and an edge 504b, a layer 506 with an edge 506a and an edge 506b, a reflective coating 508, a discontinuity 510, and an exemplary particle of one or more rare-earth elements 512. As shown in the figure, the optical element includes discontinuity 510 at one of the faces of optical element 500. Discontinuity 510 includes a zone from which the luminescent radiation passes through optical element 500. Such a discontinuity can include a groove, a recess, a dimple, a rib or a protrusion. Another modification can be made by providing a chamfer along edge 502a and edge 502b. The rest of the edges, including edge 504b, edge 506a and edge 506b, are covered with reflective coating 508, to render these layers reflective and direct the luminescent radiation through the remaining edges.

Discontinuity 510 can be used to direct the luminescent radiation to a selected portion of the optical element 500, so that the luminescent radiation can be tapped for various useful purposes.

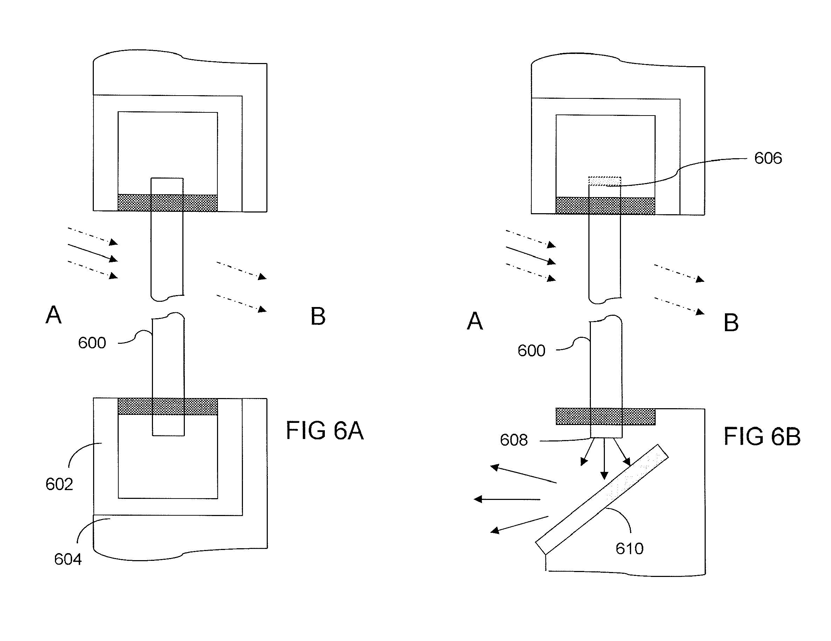

FIGS. 6A through 6E illustrate various methods for controlling luminescent radiation emitting from the optical element, in accordance with various embodiments of the present invention.

FIG. 6A shows optical element 600, a frame 602 and a wall 604 outside A that coincides with the incident radiation side, and an interior B that coincides with the transmitted radiation side. Optical element 600 is located in frame 602, fixing the optical element 600 to wall 604. The incident radiation comprising visible radiation and infrared radiation is incident on optical element 600. Optical element 600 emits the luminescent radiation, resulting in an increase in temperature in frame 602.

FIG. 6B shows optical element 600, an edge 606 coated with a mirror reflective layer, an edge 608 and a metal sheet 610. The luminescent radiation is emitted from edge 608, which has no reflective element. A small gap is left in front of edge 608, so that the luminescent radiation does not heat wall 604. The part of wall 604 on which the luminescent radiation from edge 608 impinges can be covered with metal sheet 610. In addition, edge 608 may be faceted (not shown in the figure), so that the luminescent radiation is refracted at the surface of a facet on the outside A of wall 604.

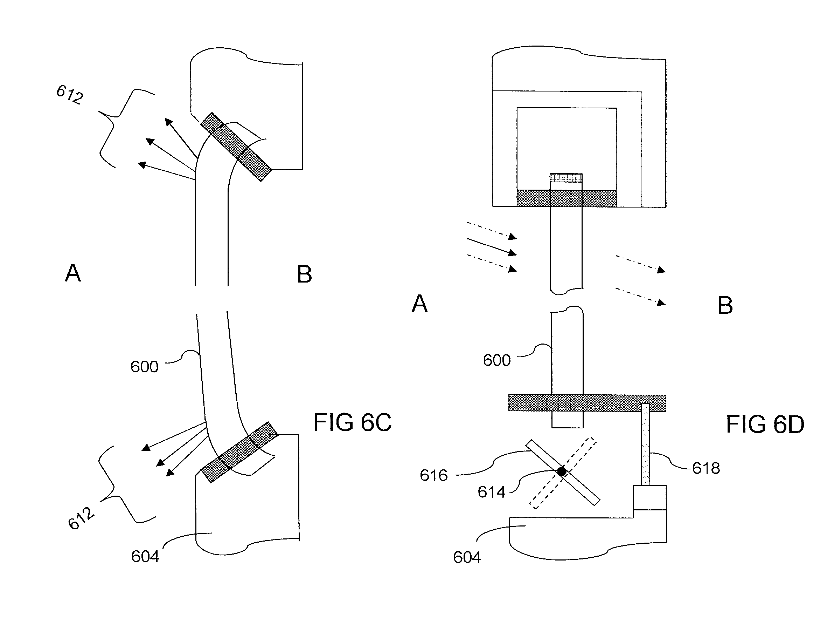

FIG. 6C shows an arrangement for protecting frame 602 and wall 604 from the luminescent radiation from rays 612. Individual portions of optical element 600 are given a convex shape. In these portions, the angles of incidence on the front surface from the internal surface of optical element 600 decreases to less than the critical angle, and therefore, total internal reflection does not occur and the luminescent radiation exits from the optical element as rays 612.

FIG. 6D shows another arrangement for protecting frame 602 and wall 604 from the luminescent radiation. The figure shows a spindle 614, a rotating mirror 616 and a glass 618. Rotating mirror 616 is attached along one of the edges of spindle 614 and may be placed in two fixed positions, which are marked in the figure in solid and broken lines. During the hot months of the year, when it is necessary to provide maximum protection from infrared radiation, rotating mirror 616 is in the position shown by the broken line. In this case, all the radiation exiting from edge 608 is reflected by mirror 616 to the outside A of wall 604. During the periods of the year when the sun is shining but the temperature is low, rotating mirror 616 is rotated to the position shown by the solid line. In this case, the luminescent radiation emitted from edge 608 and reflected by rotating mirror 616 is transmitted to the interior B through glass 618.

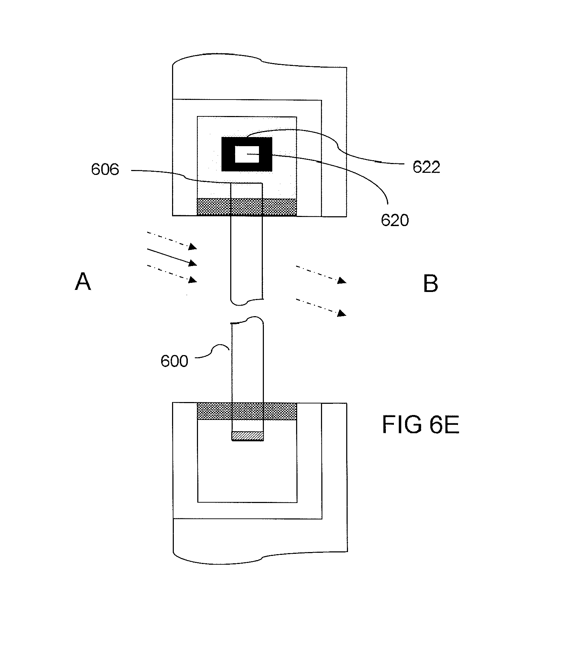

FIG. 6E shows an arrangement for tapping the luminescent radiation from optical element 600. The figure shows a radiation-tapping unit that includes an absorbing water heater 620 and a heat-insulating layer 622. Edge 606 of optical element 600 is connected to absorbing water heater 620 in the form of a pipe covered with heat insulating layer 622. The radiation-tapping unit taps the luminescent radiation emitted from the optical element through edge 606.

The luminescent radiation tapped by the radiation tapping unit, hereinafter referred to as tapped radiation, can be used for various applications. This tapped radiation can be used to provide hot water on sunny days, which can be used for everyday domestic uses or can be directed to the storage tank of the central heating system of the building. The tapped radiation can also be used in photoelectric cells for conversion of re-emitted radiation into electrical energy. Moreover, the tapped radiation can be used for decorative purposes by providing visual highlights, which are visible from the exterior of the panel.

Therefore, the present invention improves the efficiency of the inhibition of a selected portion of the incident radiation to about 80 percent. Further, the present invention permits substantial transmission of the remaining portion of the incident radiation, thereby enabling a substantially transparent optical element with effective infrared radiation-inhibiting properties. Furthermore, the present invention provides an arrangement for tapping the luminescent radiation for various useful purposes. The applications of the tapped luminescent radiation include, but are not limited to, heating, photoelectric cells, decoration, and so forth.

**Claims**

1.  An optical element comprising one or more layers, at least one of the one or more layers comprising one or more luminescent materials, the one or more luminescent materials spectrally transforming an incident radiation corresponding to a first wavelength range into a luminescent radiation, the one or more layers having such refractive indices such that a substantial portion of the luminescent radiation is subjected to total internal reflection whereby the substantial portion of the luminescent radiation is directed to an edge of the one or more layers.

2.  The optical element according to claim 1, wherein the one or more luminescent materials comprises at least one inorganic luminescent material, wherein the inorganic luminescent material may comprise at least one rare-earth element.

3.  An optical element comprising one or more layers, at least one of the one or more layers comprising one or more rare-earth elements, the one or more rare-earth elements spectrally transforming an incident radiation corresponding to a first wavelength range into a luminescent radiation, the one or more layers having such refractive indices such that a substantial portion of the luminescent radiation is subjected to total internal reflection whereby the substantial portion of the luminescent radiation is directed to an edge of the one or more layers.

4.  The optical element according to claim 3 further comprising a polymeric layer, the polymeric layer comprising one or more rare-earth elements and/or wherein the one or more layers are substantially transparent to an incident radiation corresponding to a second wavelength range and/or wherein the one or more layers comprises at least one organic glass layer and/or wherein the one or more layers are substantially transparent to an incident radiation corresponding to a second wavelength range.

5.  An optical element comprising a plurality of optically active layer, a first optically active layer of the plurality of active layers spectrally transforming an incident radiation corresponding to a first wavelength into first luminescent radiation, a portion of the first luminescent radiation being incident on a second optically active layer of the plurality of optically active layers, the second optically active layer spectrally transforming the first luminescent radiation into a second luminescent radiation.

6.  The optical element according to claim 5, wherein a portion of the second luminescent radiation is incident on a third optically active layer of the plurality of optically active layers, the third optically active layer spectrally transforming the second luminescent radiation into a third luminescent radiation.

7.  The optical element according to claim 6, wherein the plurality of optically active layers have such refractive indices that a substantial portion of the luminescent radiation is subjected to total internal reflection whereby the substantial portion of the luminescent radiation is directed to an edge of the plurality of optically active layers.

**8.** The optical element according to one of claims 5 to 7, wherein the plurality of optically active layers are substantially transparent to an incident radiation corresponding to a second wavelength range.

**9.** The optical element according to one of claims 5 to 8, wherein the plurality of optically active layers comprises at least one organic glass layer and/or one inorganic glass layer and/or more luminescent materials.

**10.** The optical element according to one of claims 1 and 9, wherein the second wavelength range is between about 400 nm to about 600 nm and/or the first wavelength range is at least one of a wavelength range between about 600 nm to about 2500 nm and a wavelength range between about 100 nm to about 400 nm.

**11.** The optical element according to one of claims 1 to 10, wherein the one or more luminescent materials comprises at least one organic luminescent material.

**12.** The optical element according to claims 2 and 3, wherein the at least one rare-earth element is selected from the group consisting of Cerium, Ytterbium, Samarium, Erbium and Terbium and combinations thereof.

**13.** The optical element according to one of claims 1 to 12, wherein at least one of the one or more layers comprises at least one of a reflecting material and a tinting material.

**14.** The optical element according to one of claims 1 to 13 further comprising a polymeric layer, the polymeric layer comprising one or more luminescent materials.

**15.** The optical element according to one of claims 1 to 14, wherein at least one of the one or more layers is formed with a discontinuity to facilitate direction of the luminescent radiation to the edge of the one or more layers.

**16.** The optical element according to one of claims 1 to 15, wherein at least one of the edges of the optical element is coated with a reflective material, the reflective material directing the luminescent radiation towards the remaining edges.

**17.** The optical element according to one of claims 1 to 16, wherein the optical element is used as a window pane in a building or wherein the optical element is used in an automobile as one of a window pane, a windshield, a sunroof, and a sun visor.

**18.** A radiation inhibiting system comprising:

a. an optical element, according to one of claims 1 to 17; and
b. a radiation tapping unit, the radiation tapping unit tapping the substantial portion of the luminescent radiation emitted from the edge of the one or more layers.

FIG 1

100

FIG 2

EP 2 056 361 A1

Visible

IR

312

314

302

310

304 306 308

300

FIG 3

FIG 4

400

FIG 5

Visible

IR

FIG 6B

FIG 6A

FIG 6C

FIG 6D

FIG 6E

A

B

600

606

620

622

Europäisches
Patentamt

European
Patent Office

Office européen
des brevets

## EUROPEAN SEARCH REPORT

Application Number

EP 08 10 3860

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 97/44690 A (TROPIGLAS PTY LTD [AU]; BARANOV VLADIMIR KUZMICH [RU]; MUSKI MICHAEL []) 27 November 1997 (1997-11-27) <br> * page 4, line 23 - line 29; figures 1-3,4b * <br> * page 5, line 12 - line 30 * <br> * page 6, line 1 - line 19 * <br> * page 1, line 11 - line 16 * <br> * page 8, line 1 - line 7 * <br> * page 4, line 7 - line 9 * <br> * page 7, line 11 - line 15 * | 1-5,10, 11,13-18 | INV. <br> H01L31/055 <br> F21V8/00 <br> F24J2/06 |
| X | US 4 412 528 A (ELZINGA JR EUGENE R [US]) 1 November 1983 (1983-11-01) <br> * column 1, line 66; figures 1-3 * <br> * column 2, line 9 - line 15 * <br> * abstract * | 1-4,11, 17,18 | |
| X | US 4 488 047 A (THOMAS WILLIAM R L [US]) 11 December 1984 (1984-12-11) <br> * abstract; figures 1,3 * <br> * column 2, line 23 - line 28 * <br> * column 2, line 48 - line 68 * | 1-9 | TECHNICAL FIELDS SEARCHED (IPC) <br><br> G02B <br> C09B <br> H01L <br> F24J <br> B32B |
| X | US 4 190 465 A (BOLING NORMAN L [US]) 26 February 1980 (1980-02-26) <br> * column 2, line 19 - line 34 * <br> * column 4, line 51 - line 65; figures 2,3 * | 1,5-9 | |
| X | WO 2007/045917 A (SOLARSTRUCTURE LTD [GB]; MAZZER MASSIMO [GB]; CLIVE BARRY MICHAEL [GB]) 26 April 2007 (2007-04-26) <br> * page 3, line 8 - line 12; figures 6,8 * <br> * page 22, line 1 - line 3 * | 1-3,12 | |

The present search report has been drawn up for all claims

| Place of search | Date of completion of the search | Examiner |
|---|---|---|
| Munich | 26 February 2009 | Jones, Julian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 08 10 3860

This annex lists the patent family members relating to the patent documents cited in  the above-mentioned European search report.
The members are as contained in the European Patent Office EDP file on
The European Patent Office is in no way liable for these particulars which are merely given for the purpose of information.

26-02-2009

| Patent document cited in search report | | Publication date | Patent family member(s) | | Publication date |
|---|---|---|---|---|---|
| WO 9744690 | A | 27-11-1997 | US | 6285495 B1 | 04-09-2001 |
| US 4412528 | A | 01-11-1983 | NONE | | |
| US 4488047 | A | 11-12-1984 | NONE | | |
| US 4190465 | A | 26-02-1980 | NONE | | |
| WO 2007045917 | A | 26-04-2007 | EP | 1952448 A2 | 06-08-2008 |
| | | | GB | 2431513 A | 25-04-2007 |

EPO FORM P0459

For more details about this annex : see Official Journal of the European Patent Office, No. 12/82